# EUROPÄISCHE PATENTSCHRIFT

(11) **EP 1 770 794 B1**
(45) Veröffentlichungstag und Bekanntmachung des Hinweises auf die Patenterteilung: **30.08.2017**
(21) Anmeldenummer: 06019686.2
(22) Anmeldetag: 20.09.2006
(51) Int. Cl.: H01L 33/42, H01L 33/50, H01L 51/50, H01L 51/52, B82Y 20/00, B82Y 30/00

(54) **Optoelektronische Halbleiterchip, Verfahren zu dessen Herstellung und optoelektronisches Bauteil**
Optoelectronic semiconductor chip, method of manufacturing the same and optoelectronic device
Puce optoélectronique semiconductrice, son procédé de fabrication et dispositif optoélectronique

(30) Priorität: 28.09.2005 DE 102005046450
(43) Veröffentlichungstag der Anmeldung: 04.04.2007
(73) Patentinhaber: OSRAM Opto Semiconductors GmbH, 93055 Regensburg (DE)
(72) Erfinder: von Malm, Norwin, 93186 Pettendorf (DE)
(74) Vertreter: Epping - Hermann - Fischer

(56) Entgegenhaltungen:
- EP-A- 0 877 099
- EP-A- 1 439 585
- WO-A-2006/049146
- JP-A- 11 087 778
- JP-A- 2002 164 576
- US-A1- 2005 093 008

## Beschreibung

Es wird ein optoelektronischer Halbleiterchip, ein optoelektronisches Bauteil mit solch einem Halbleiterchip und ein Verfahren zur Herstellung eines solchen optoelektronischen Halbleiterchips angegeben.

JP H11-087778 offenbart ein optoelektronischer Halbleiterchip mit einer Strahlungsdurchtrittsfläche, die sich mit einer Stromaufweitungsschicht in Kontakt befindet, wobei die Stromaufweitungsschicht Partikel enthält, die ein Wellenlängenkonversionsmaterial umfassen.

JP 2002164576 offenbart ein Verfahren zur Herstellung eines optoelektronischen Halbleiterchips, mit die Schritten: Bereitstellen einer Lösung von In (C7-H15C00), Sn(C7-H15C00) und eines Wellenlängenkonversionsmaterials in Pulverform, Aufbringen einer Schicht dieser Lösung auf zumindest Teile der Oberfläche eines Halbleiterchips, und thermisches Behandeln der aufgebrachten Schicht zur Überführung der Lösung in eine elektrisch leitende Schicht.

US 2005/0093008 offenbart ein optoelektronischer Halbleiterchip mit einer Schicht die Partikel enthält, wobei die Partikel ein Wellenlängenkonversionsmaterial umfassen und einen mittleren Durchmesser aufweisen, der größer ist als die mittlere Schichtdicke, und wobei die Schicht die Partikel vollständig benetzt.

Eine zu lösende Aufgabe besteht darin, einen optoelektronischen Halbleiterchip anzugeben, der besonders kostengünstig herstellbar ist. Eine weitere Aufgabe besteht darin, ein optoelektronisches Bauteil mit solch einem Halbleiterchip, sowie ein Verfahren zur Herstellung eines solchen optoelektronischen Halbleiterchips anzugeben.

Gemäß der Erfindung weist der optoelektronische Halbleiterchip eine Strahlungsdurchtrittsfläche auf. Die Strahlungsdurchtrittsfläche ist eine Fläche, durch die elektromagnetische Strahlung in den optoelektronischen Halbleiterchip eintreten kann oder durch die optoelektronische Strahlung aus dem Halbleiterchip ausgekoppelt wird. Mit anderen Worten tritt mit dem Chip wechselwirkende Strahlung durch die Strahlungsdurchtrittsfläche. Es handelt sich bei der Strahlungsdurchtrittsfläche also um eine Strahlungseintritts- oder -austrittsfläche des optoelektronischen Halbleiterchips. Bevorzugt ist die Strahlungsdurchtrittsfläche durch zumindest einen Teil der Oberfläche des optoelektronischen Halbleiterchips gegeben. Beispielsweise kann die Strahlungsdurchtrittsfläche durch den Teil der Hauptfläche des optoelektronischen Halbleiterchips gegeben sein oder eine Hauptfläche des optoelektronischen Halbleiterchips umfassen.

Gemäß der Erfindung befindet sich die Strahlungsdurchtrittsfläche mit einer Stromaufweitungsschicht in Kontakt. Das heißt beispielsweise, dass die Stromaufweitungsschicht die Strahlungsdurchtrittsfläche zumindest stellenweise bedeckt und dadurch geeignet ist, elektrischen Strom durch die Strahlungsdurchtrittsfläche hindurch in den Halbleiterchip einzuprägen.
Zum Beispiel ist die Stromaufweitungsschicht dabei auf die Stromaufweitungsschicht aufgebracht. "Aufgebracht" bedeutet, dass die Stromaufweitungsschicht vorzugsweise nicht monolithisch in den Halbleiterchip integriert ist. Das heißt, die Stromaufweitungsschicht ist bevorzugt nicht gemeinsam mit einer anderen Halbleiterschicht des optoelektronischen Halbleiterchips, beispielsweise in einem Epitaxiereaktor epitaktisch aufgewachsen, sondern die Stromaufweitungsschicht ist vorzugsweise nachträglich, das heißt, nach dem das Wachstum des optoelektronischen Halbleiterchips abgeschlossen ist, auf die Strahlungsdurchtrittsfläche des optoelektronischen Halbleiterchips aufgebracht. Alternativ ist es auch möglich, dass der Halbleiterchip mit seiner Strahlungsdurchtrittsfläche auf die Stromaufweitungsschicht aufgebracht ist.
Die Stromaufweitungsschicht bezeichnet eine elektrisch leitende Schicht. Die Stromaufweitungsschicht (auch: current spreading layer) ist geeignet, einen beispielsweise mittels einer Anschlussstelle (Bondpad), injizierten elektrischen Strom über die Strahlungsdurchtrittsfläche des optoelektronischen Halbleiterchips möglichst gleichmäßig zu verteilen. Die Anschlussstelle kann dazu auf einen Teil der Stromaufweitungsschicht aufgebracht sein. Der so über die Strahlungsdurchtrittsfläche des optoelektronischen Halbleiterchips verteilte elektrische Strom dient dann im optoelektronischen Halbleiterchip beispielsweise zur Strahlungserzeugung.

Die Stromaufweitungsschicht weist vorzugsweise eine gute Querleitfähigkeit auf. Das heißt, die Leitfähigkeit der Schicht in Richtungen, die parallel zur Strahlungsdurchtrittsfläche verlaufen, ist besonders hoch. Ferner weist die Stromaufweitungsschicht bevorzugt eine gute Leitfähigkeit in Richtung senkrecht oder im Wesentlichen senkrecht zur Strahlungsdurchtrittsfläche auf. So kann der elektrische Strom von der Oberfläche der Stromaufweitungsschicht, die der Strahlungsdurchtrittsfläche abgewandt ist, besonders gut zur Strahlungsdurchtrittsfläche des Chips geleitet und über die gesamte Strahlungsdurchtrittsfläche verteilt werden.

Bevorzugt ist die Stromaufweitungsschicht direkt auf die Strahlungsdurchtrittsfläche des optoelektronischen Halbleiterchips aufgebracht. Das heißt, sie grenzt bevorzugt unmittelbar an eine beispielsweise epitaktisch gewachsene Außenfläche des optoelektronischen Halbleiterchips an. Die Stromaufweitungsschicht ist dabei bevorzugt zumindest für einen Teil der elektromagnetischen Strahlung, die aus dem optoelektronischen Halbleiterchip durch die Strahlungsdurchtrittsfläche austritt oder durch die Strahlungsdurchtrittsfläche in den optoelektronischen Halbleiterchip eintritt, transparent. Bevorzugt beträgt die optische Transparenz der Stromaufweitungsschicht im sichtbaren Spektralbereich wenigstens 90 Prozent.

Gemäß der Erfindung enthält die Stromaufweitungsschicht ein Wellenlängenkonversionsmaterial. Ein Wellenlängenkonversionsmaterial bezeichnet dabei ein Material, das geeignet ist, elektromagnetische Strahlung einer ersten Wellenlänge oder eines ersten Wellenlängenbereichs zu absorbieren und elektromagnetische Strahlung einer zweiten Wellenlänge oder eines zweiten Wellenlängenbereichs zu reemittieren. Dabei kann es sich bei der elektromagnetischen Strahlung der zweiten Wellenlänge oder des zweiten Wellenlängenbereichs um Strahlung mit einer kürzeren Wellenlänge als die des ersten Wellenlängenbereichs handeln. Bevorzugt handelt es sich jedoch bei der konvertierten Strahlung um langwelligere Strahlung, als die der ersten Wellenlänge oder des ersten Wellenlängenbereichs. Das Wellenlängenkonversionsmaterial liegt bevorzugt in Partikelform vor oder es sind in der Stromaufweitungsschicht Partikel enthalten, die ein Wellenlängenkonversionsmaterial enthalten. Das heißt, die Stromaufweitungsschicht enthält bevorzugt Partikel eines Wellenlängenkonversionsmaterials.

Gemäß der Erfindung weist der optoelektronische Halbleiterchip eine Strahlungsdurchtrittsfläche auf, auf die eine Stromaufweitungsschicht aufgebracht ist, die Partikel enthält, die ein Wellenlängenkonversionsmaterial umfassen. Dem optoelektronischen Halbleiterchip liegt dabei unter anderem die Idee zugrunde, dass das Eindringen des Wellenlängenkonversionsmaterials direkt in die Stromaufweitungsschicht eine besonders einfache Herstellung des optoelektronischen Halbleiterchips ermöglicht, da ein Herstellungsschritt - nämlich das Aufbringen einer von der Stromaufweitungsschicht separaten Wellenlängenkonversionsschicht - entfallen kann. Ferner liegt dem optoelektronischen Halbleiterchip unter anderem die Erkenntnis zugrunde, dass die Partikel des Wellenlängenkonversionsmaterials Mehrfachreflexionen von elektromagnetischer Strahlung an der Stromaufweitungsschicht unterdrücken können, da sie unter Anderem eine Aufrauung der Oberfläche dieser Schicht bewirken. Auf diese Weise kann vorteilhaft die Wahrscheinlichkeit für Auskopplung elektromagnetischer Strahlung aus dem optoelektronischen Halbleiterchip durch die Stromaufweitungsschicht hindurch erhöht sein. Außerdem ermöglicht eine Stromaufweitungsschicht mit Wellenlängenkonversionsmaterial das Aufbringen des Wellenlängenkonversionsmaterials möglichst nahe an der Strahlungsdurchtrittsfläche des Halbleiterchips. Dadurch kann der Konversionsgrad der austretenden Strahlung erhöht sein und/oder der Farbeindruck von Mischstrahlung elektromagnetischer Strahlung des ersten und des zweiten Wellenlängenbereichs ist besonders gleichmäßig und unabhängig vom Betrachtungswinkel.

Gemäß zumindest einer Ausführungsform des optoelektronischen Halbleiterchips, vermittelt die Stromaufweitungsschicht eine Haftung zwischen den Partikeln des Wellenlängenkonversionsmaterials und der Strahlungsdurchtrittsfläche des optoelektronischen Halbleiterchips. Das heißt, die Stromaufweitungsschicht haftet an der Strahlungsdurchtrittsfläche und die Partikel des Lumineszenzkonversionsmaterials haften an der Stromaufweitungsschicht. Die Stromaufweitungsschicht vermittelt dadurch einen mechanischen Halt der Partikel des Wellenlängenkonversionsmaterials auf der Strahlungsdurchtrittsfläche.
Partikel des Wellenlängenkonversionsmaterials können sich dabei in direktem Kontakt mit der Strahlungsdurchtrittsfläche befinden und/oder es befindet sich Material der Stromaufweitungsschicht zwischen den Partikeln und der Strahlungsdurchtrittsfläche.
Mit anderen Worten kann die Stromaufweitungsschicht im Sinne eines Klebstoffs oder Haftmittels Verwendung finden, mit dessen Hilfe die Partikel des Wellenlängenkonversionsmaterials auf die Strahlungsdurchtrittsfläche des Halbleiterchips geklebt sind. Gleichzeitig dient die Stromaufweitungsschicht zur Verteilung von elektrischem Strom über die gesamte Oberfläche des optoelektronischen Halbleiterchips, die als Strahlungsdurchtrittsfläche dient. So ist eine möglichst gleichmäßige Bestromung des optoelektronischen Halbleiterchips erreicht.

Gemäß der Erfindung ist die Schichtdicke der Stromaufweitungsschicht zumindest stellenweise kleiner, als der mittlere Durchmesser der Partikeln des Wellenlängenkonversionsmaterials. Die Schichtdicke der Stromaufweitungsschicht an einer bestimmten Stelle der Schicht ist dabei durch die kürzeste Verbindung von einem Punkt auf einer Hauptfläche der Stromaufweitungsschicht zur gegenüberliegenden Hauptfläche der Stromaufweitungsschicht gegeben.

Der mittlere Durchmesser der Partikel des Wellenlängenkonversionsmaterials ist bevorzugt als mittlerer Partikeldurchmesser d50 in Q0 gemessen. Der Ausdruck "d50 in Q0 gemessen" bezeichnet dabei den Median des Korndurchmessers des Wellenlängenkonversionsmaterials, der aus einer kumulativen Volumen- oder Masseverteilung der Partikel, die vermessen werden, ermittelt ist. Zur Definition dieses Ausdrucks wird auch auf den internationalen Standard ISO 9276-2 verwiesen. Bevorzugt beträgt der mittlere Durchmesser der Partikel des Wellenlängenkonversionsmaterials zwischen einem und 20 Mikrometer. Dabei ist es insbesondere auch möglich, dass die Stromaufweitungsschicht Partikel unterschiedlicher Wellenlängenkonversionsmaterialen enthält, die jeweils unterschiedliche mittlere Korndurchmesser aufweisen können. Bevorzugt ist der mittlere Korndurchmesser jeder der verwendeten Partikel zumindest stellenweise größer als die minimale Schichtdicke der Stromaufweitungsschicht.
Besonders bevorzugt ist der mittlere Partikeldurchmesser des Wellenlängenkonversionsmaterials auch größer als die mittlere Schichtdicke der Stromaufweitungsschicht. Das heißt, die über die gesamte Stromaufweitungsschicht gemittelte Schichtdicke der Stromaufweitungsschicht ist dann kleiner als der mittlere Partikeldurchmesser.
Mit anderen Worten sind bei einer mikroskopischen Betrachtung der Stromaufweitungsschicht die Partikel des Wellenlängenkonversionsmaterials als Ausbuchtungen der Stromaufweitungsschicht zu erkennen. Die Partikel sind in diesem Fall also nicht in einem Block aus dem Material der Stromaufweitungsschicht angeordnet, sondern das Material der Stromaufweitungsschicht umformt die Partikel des Wellenlängenkonversionsmaterials derart, dass die Kontur der von der Strahlungsdurchtrittsfläche abgewandten Oberseite der Stromaufweitungsschicht durch die Partikel des Wellenlängenkonversionsmaterials mitbestimmt ist.

Gemäß zumindest einer Ausführungsform des optoelektronischen Halbleiterchips beträgt die Schichtdicke der Stromaufweitungsschicht zumindest stellenweise zwischen 0,1 und 2,0 Mikrometer. Bevorzugt beträgt die mittlere Schichtdicke der Stromaufweitungsschicht zwischen 0,2 und 2,0 Mikrometer. Solch eine dünne Stromaufweitungsschicht absorbiert besonders wenig der durch sie tretenden elektromagnetischen Strahlung und kann dennoch den in sie eingeprägten Strom besonders gleichmäßig über die gesamte Strahlungsdurchtrittsfläche verteilen.

Gemäß zumindest einer Ausführungsform des optoelektronischen Halbleiterchips benetzt das Material der Stromaufweitungsschicht die Partikel des Wellenlängenkonversionsmaterials zumindest stellenweise. Besonders bevorzugt sind Partikel des Wellenlängenkonversionsmaterials allseitig vom Material der Stromaufweitungsschicht umgeben. Das heißt, das Material der Stromaufweitungsschicht benetzt die Partikel des Wellenlängenkonversionsmaterials vollständig. In diesem Fall befindet sich das Material der Stromaufweitungsschicht sowohl zwischen einem Partikel des Wellenlängenkonversionsmaterials und der Strahlungsdurchtrittsfläche als auch auf von der Strahlungsdurchtrittsfläche abgewandten Außenflächen des Partikels. Mit anderen Worten sind die Partikel des Wellenlängenkonversionsmaterials dann mit einer dünnen Schicht aus dem Material der Stromaufweitungsschicht überzogen. Die Kontur der von der Strahlungsdurchtrittsfläche abgewandten Oberfläche der Stromaufweitungsschicht ist vorzugsweise durch die Partikel des Wellenlängenkonversionsmaterials bestimmt.

Gemäß der Erfindung enthält die Stromaufweitungsschicht elektrisch leitende Nanopartikel. Beispielsweise enthält die Stromaufweitungsschicht Nanopartikel, die mit einem Dotiermaterial dotiert sind. Die elektrische Leitfähigkeit der Nanopartikel ist dann durch die Dotierung erhöht oder bestimmt. Der mittlere Durchmesser (zum Beispiel d50 in Q0 gemessen) der Nanopartikel der Stromaufweitungsschicht beträgt dabei zwischen wenigstens einem Nanometer und maximal 100 Nanometer, besonders bevorzugt zwischen wenigstens einem Nanometer und maximal 30 Nanometer.

Gemäß zumindest einer Ausführungsform des optoelektronischen Halbleiterchips enthält die Stromaufweitungsschicht ein Sol-Gel-Material. Das heißt, bei Auftragung der Stromaufweitungsschicht auf die Strahlungsdurchtrittsfläche des optoelektronischen Halbleiterchips befindet sich das Material der Stromaufweitungsschicht bevorzugt in einem Sol-Zustand. Das Sol umfasst dabei bei Auftragung auf die Strahlungsdurchtrittsfläche beispielsweise ein Lösungsmittel und die elektrisch leitenden Nanopartikel, die im Lösungsmittel enthalten sind. Weiter enthält das Sol bevorzugt auch die Partikel des Wellenlängenkonversionsmaterials. Nach dem Aufbringen des Sols auf die Strahlungsdurchtrittsfläche wird das Sol beispielsweise durch Entzug des Lösungsmittels zu einem Gel destabilisiert. Auf diese Weise ist eine Gel-Schicht auf der Strahlungsdurchtrittsfläche des Halbleiterchips ausgebildet, die elektrisch leitende Nanopartikel und Partikel des Wellenlängenkonversionsmaterials enthält. Durch thermische Behandlung des Gels bei Temperaturen zwischen vorzugsweise 200 Grad Celsius und 400 Grad Celsius entsteht eine glasartige Schicht mit geringerem elektrischem Schichtwiderstand als die die ursprüngliche Gel-Schicht.

Dadurch ist auf der Strahlungsdurchtrittsfläche eine Schicht aufgebracht, die zur Stromaufweitung geeignet ist, die zur Wellenlängenkonversion der durch sie tretenden elektromagnetischen Strahlung geeignet ist und die aufgrund der in die Schicht eingebundenen Partikel des Wellenlängenkonversionsmaterials eine mehrfache Totalreflexion des Lichts innerhalb der Schicht unterdrückt und damit auch die Lichtauskopplung aus dem Halbleiterchip vorteilhaft verbessert.

Bevorzugt haftet diese Schicht auf der Strahlungsdurchtrittsfläche. Das heißt, Strahlungsdurchtrittsfläche und Stromaufweitungsschicht sind so gewählt, dass nach dem Beschichten ein Gel-Film auf dem Körper haftet, der sich einem Ablösen - beispielsweise mittels mechanischer Krafteinwirkung - zumindest in bestimmten Grenzen widersetzt. Das heißt beispielsweise, dass sich bei Weiterverarbeitung des beschichteten Halbleiterchips die Schicht nicht von der Strahlungsdurchtrittsfläche löst.

Gemäß zumindest einer Ausführungsform des optoelektronischen Halbleiterchips enthält die Stromaufweitungsschicht zumindest eines der folgenden Nanopartikel: Zinkoxid-Nanopartikel, Zinnoxid-Nanopartikel. Auch weitere Nanopartikel so genannter TCO (transparent conductive oxide) Materialien können als Nanopartikel für die Stromaufweitungsschicht Verwendung finden. Beispielsweise sind die Nanopartikel mit wenigstens einem der folgenden Materialien dotiert: Bor, Aluminium, Gallium, Indium, Silizium, Magnesium, Cadmium.

Die Stromaufweitungsschicht kann also beispielsweise ein mit Aluminium dotiertes Zinkoxid-Sol-Gel-Material oder ein mit Indium dotiertes Zinnoxid-Sol-Gel-Material enthalten. Weitere mögliche Metalloxide in der Stromaufweitungsschicht sind durch folgende Oxide gegeben: ZnO, SnO₂ CdSnO₃, In₂O₃, Zn₂SnO₄, ZnSnO₃, MgIn₂O₄, GaInO₃, Zn₂In₂O₅, In₄Sn₃O₁₂ oder Mischungen.

Gemäß zumindest einer Ausführungsform des optoelektronischen Halbleiterchips umfasst das Wellenlängenkonversionsmaterial Partikel zumindest eines der folgenden Farbstoffe: organischen Farbstoff, anorganischen Farbstoff. Bevorzugt umfasst das Wellenlängenkonversionsmaterial Partikel zumindest eines der folgenden Farbstoffe: mit Metallen der seltenen Erden dotierte Granate, mit Metallen der seltenen Erden dotierte Erdalkalisulfide, mit Metallen der seltenen Erden dotierte Thiogallate, mit Metallen der seltenen Erden dotierte Aluminate, mit Metallen der seltenen Erden dotierte Orthosilikate, mit Metallen der seltenen Erden dotierte Chlorosilikate, mit Metallen der seltenen Erden dotierte Erdalkalisiliziumnitride, mit Metallen der seltenen Erden dotierte Oxynitride, mit Metallen der seltenen Erden dotierte Aluminiumoxynitride.

Besonders bevorzugt umfasst das Wellenlängenkonversionsmaterial dotierte Granate wie Ce- oder Tb-aktivierte Granate wie YAG:Ce, TAG:Ce, TbYAG:Ce. Beispiele für geeignete Wellenlängenkonversionsmaterialien sind in den Druckschriften WO 97/50132 A1, WO 98/12757 A1 und WO 01/08452 A1 angegeben, deren Offenbarungsgehalte insofern hiermit ausdrücklich durch Rückbezug aufgenommen werden.

Gemäß zumindest einer Ausführungsform des optoelektronischen Halbleiterchips ist der optoelektronische Halbleiterchip durch eines der folgenden optoelektronischen Bauelemente gegeben: Fotodiodenchip, Laserdiodenchip, anorganischer Leuchtdiodenchip.

Handelt es sich bei dem optoelektronischen Halbleiterchip um einen Laserdiodenchip oder einen Leuchtdiodenchip, so ist die Stromaufweitungsschicht mit dem Wellenlängenkonversionsmaterial bevorzugt zumindest stellenweise auf die Strahlungsdurchtrittsfläche des Chips aufgebracht. Handelt es sich bei dem optoelektronischen Halbleiterchip um einen Fotodiodenchip, so ist die Stromaufweitungsschicht mit dem Wellenlängenkonversionsmaterial bevorzugt auf die Strahlungseintrittsfläche des Fotodiodenchips aufgebracht.

Gemäß zumindest einer Ausführungsform des optoelektronischen Halbleiterchips ist der optoelektronische Halbleiterchip durch einen organischen Leuchtdiodenchip gegeben. Das heißt, der Halbleiterchip enthält ein organisches Halbleitermaterial. In diesem Fall ist es auch möglich, dass die Stromaufweitungsschicht auf einen Träger - beispielsweise ein Glassubstrat - aufgebracht ist und der Halbleiterkörper nachträglich auf die Stromaufweitungsschicht aufgebracht ist. Beispielsweise kann das Material des Halbleiterkörpers dann auf die Stromaufweitungsschicht aufgeschleudert, aufgerakelt, aufgedruckt oder aufgedampft sein.

Ein Aufbringen der Stromaufweitungsschicht auf beispielsweise ein Glassubstrat kann sich als besonders vorteilhaft erweisen, da ein eventuell notwendiger Temperschritt zur Erzeugung der Stromaufweitungsschicht auf diesem Träger erfolgen kann. Alternativ kann die Stromaufweitungsschicht auch auf den Halbleiterkörper, der ein organisches Halbleitermaterial enthält, aufgebracht sein. In diesem Fall finden vorteilhaft besonders temperaturbeständige organische Halbleitermaterialien Verwendung, die ein eventuelles Tempern der Stromaufweitungsschicht unbeschadet überstehen.

Es wird ferner ein optoelektronisches Bauteil mit einem Halbleiterchip gemäß zumindest einem der oben beschriebenen Ausführungsformen angegeben.

Gemäß zumindest einer Ausführungsform weist das optoelektronische Bauteil einen optoelektronischen Halbleiterchip gemäß zumindest einer der oben beschriebenen Ausführungsformen auf sowie wenigstens zwei elektrische Anschlussstellen, über die das Bauteil von außerhalb des Bauteils kontaktierbar ist. Geeignete Bauformen für das optoelektronische Bauteil sind beispielsweise in den Druckschriften WO 2004/088200 und WO 02/084749 beschrieben. Gemäß zumindest einer Ausführungsform des optoelektronischen Bauteils weist das Bauteil einen Formkörper auf. Der Formkörper umschließt den Halbleiterchip beispielsweise von wenigstens fünf Seiten vollständig. Bevorzugt befindet sich der Formkörper dabei zumindest stellenweise in direktem Kontakt mit der oben beschriebenen Stromaufweitungsschicht des optoelektronischen Halbleiterchips.
Der Formkörper ist beispielsweise aus einer transparenten Vergussmasse gebildet, die zumindest eines der folgenden Materialien enthalten kann: Epoxidharz, Silikonharz, PMMA. Der Formkörper kann ferner ein Material zur Anpassung des Brechungsindex - zum Beispiel ein Kopplungsgel oder ein Index Matching Gel - an ein optisches Element, das dem Halbleiterchip in Hauptabstrahlrichtung nachgeordnet ist, umfassen.
Der Formkörper ist bevorzugt zumindest stellenweise für die vom optoelektronischen Halbleiterchip abgegebene elektromagnetische Strahlung transparent. Bevorzugt ist er sowohl für den konvertierten als auch den nicht konvertierten Anteil der Strahlung transparent oder strahlungsdurchlässig.

Gemäß zumindest einer Ausführungsform des optoelektronischen Bauteils enthält der Formkörper ein Wellenlängenkonversionsmaterial. Beispielsweise kann der Formkörper wenigstens eines der oben genannten Wellenlängenkonversionsmaterialien enthalten. Bevorzugt enthält der Formkörper dann Partikel dieses Wellenlängenkonversionsmaterials. Dabei kann das Wellenlängenkonversionsmaterial geeignet sein, vom Halbleiterchip im Betrieb erzeugte elektromagnetische Strahlung der ersten Wellenlänge oder des ersten Wellenlängenbereichs zumindest teilweise zu konvertieren. Weiter ist es möglich, dass das Wellenlängenkonversionsmaterial in der Formmasse geeignet ist, bereits in der Stromaufweitungsschicht konvertierte elektromagnetische Strahlung der zweiten Wellenlänge oder des zweiten Wellenlängenbereichs zu konvertieren.

Weiter kann das Wellenlängenkonversionsmaterial der Stromaufweitungsschicht beispielsweise geeignet sein, vom optoelektronischen Halbleiterchip abgegebene elektromagnetische Strahlung im ultravioletten Spektralbereich in sichtbares Licht zu konvertieren. Dies hat dann auch den Vorteil, dass eine Alterung des Materials des Formkörpers aufgrund dieser ultravioletten Strahlung gemindert oder verhindert wird, da diese ultraviolette Strahlung bereits in der Stromaufweitungsschicht zu größeren Wellenlängen hin konvertiert wird.

Es wird ferner ein Verfahren zur Herstellung eines optoelektronischen Halbleiterchips gemäß zumindest einer der oben beschriebenen Ausführungsformen angegeben.

Gemäß zumindest einer Ausführungsform des Verfahrens wird zunächst ein Sol bereitgestellt, das elektrisch leitende Nanopartikel - dotierte Nanopartikel - und Partikel eines Wellenlängenkonversionsmaterials umfasst. Zumindest eine Schicht dieses Sols wird im folgenden Verfahrensschritt auf die Oberfläche eines Körpers aufgebracht. Beispielsweise wird das Sol auf die Strahlungsdurchtrittsfläche eines optoelektronischen Halbleiterchips aufgebracht. Bevorzugt erfolgt das Aufbringen dabei auf die Strahlungsdurchtrittsfläche von optoelektronischen Halbleiterchips, die im Wafer-Verbund vorliegen. Das heißt, das Sol wird bevorzugt auf einen Wafer, der eine Mehrzahl von optoelektronischen Halbleiterchips umfasst, aufgebracht. Anschließend wird zumindest die aufgebrachte Schicht thermisch behandelt, um das Sol in ein Gel zu überführen. Dabei wird beispielsweise ein Lösungsmittel in dem die Nanopartikel und die Partikel des Wellenlängenkonversionsmaterials gelöst sind, zumindest teilweise entzogen. Bei einer Beschichtung im Wafer-Verbund kann in einem abschließenden Verfahrensschritt der Wafer in einzelne optoelektronische Halbleiterchips vereinzelt werden. Es ist aber auch möglich, dass das Sol auf einen Träger - zum Beispiel auf ein Glassubstrat - aufgebracht wird. Dies erweist sich vor allem bei der Herstellung eines organischen Leuchtdiodenchips als besonders vorteilhaft.

Gemäß der Erfindung wird das Material nach dem Beschichten des Körpers getrocknet. Das heißt, zumindest der überwiegende Teil des Lösungsmittels wird dem Sol nach dem Beschichten beispielsweise durch Aufheizen entzogen. Während des Trockenprozesses entsteht ein netzwerkartiges, polymerisiertes Gel, das im Sinne eines Haftmittels eine Haftung zwischen den Partikeln des Wellenlängenkonversionsmaterials und der Strahlungsdurchtrittsfläche des optoelektronischen Halbleiterchips vermitteln kann.

Gemäß zumindest einer Ausführungsform des Verfahrens wird der Körper mittels eines der folgenden Beschichtungsverfahren beschichtet: Sprühen, Tauchbeschichten, Rotationsbeschichten, Siebdrucken, Aufrakeln, Strahldrucken (Inkjet printing), Aufpinseln. Dabei ist es je nach verwendetem Verfahren auch möglich, die Schicht strukturiert auf die Strahlungsdurchtrittsfläche aufzubringen.

Die Filmdicke einer derart aufgetragenen Schicht ist dabei zum einen durch die Parameter des gewählten Beschichtungsverfahrens und zum anderen durch die Konzentration des verwendeten Sols einstellbar. Je geringer beispielsweise die Konzentration des Sol-Gel-Materials im Lösungsmittel ist, desto dünner ist bei gleichem Beschichtungsverfahren der erzeugte Gel-Film.

Gemäß zumindest einer Ausführungsform des hier beschriebenen Verfahrens wird die Gel-Schicht, die die leitenden Nanopartikel und die Partikel des Wellenlängenkonversionsmaterials umfasst, zur Verbesserung ihrer Leitfähigkeit und ihrer optischen Eigenschaften einer Infiltration unterzogen. Die Infiltration kann zum Beispiel durch Tauchen in eine Infiltrationslösung bei erhöhter Temperatur erfolgen. Dazu umfasst die Infiltrationslösung beispielsweise ein Sol mit Kristalliten sehr geringer Größe. Damit ist es möglich sowohl die elektrischen als auch die optischen Eigenschaften der Schicht gezielt einzustellen.

Gemäß zumindest einer Ausführungsform wird beispielsweise im Anschluss an die Infiltration die Schicht bei Temperaturen zwischen 200 und 600 Grad Celsius bevorzugt zwischen 300 und 500 Grad Celsius, besonders bevorzugt bei circa 400 Grad Celsius getempert. Das Tempern erfolgt vorzugsweise unter reduzierender Atmosphäre - beispielsweise in einem H₂/N₂-Gemisch. Durch das Tempern entsteht eine nanokristalline glasartige Schicht, die reduzierende Atmosphäre unterdrückt das Entstehen von tiefen Ladungsträgerfallen durch Sauerstoff an der Oberfläche und / oder den Korngrenzen der Stromaufweitungsschicht. Das Tempern erweist sich dabei besonders zur Reduzierung des Schichtwiderstands als vorteilhaft.
Im Folgenden wird der optoelektronische Halbleiterchip, das hier beschriebene Verfahren zur Herstellung eines optoelektronischen Halbleiterchips sowie das hier beschriebene optoelektronische Bauteil anhand von beispielhaften Ausführungsbeispielen und den dazugehörigen Figuren näher beschrieben. Gleiche oder gleich wirkende Bestandteile der Figuren sind dabei mit den gleichen Bezugszeichen versehen. Die dargestellten Bestandteile, sowie die Größenverhältnisse der Bestandteile untereinander sind nicht als maßstabsgerecht anzusehen. Vielmehr sind einige Details der Figuren zum besseren Verständnis übertrieben groß dargestellt.
Figur 1 zeigt eine schematische Schnittdarstellung eines Ausführungsbeispiels des hier beschriebenen optoelektronischen Halbleiterchips.
Figur 2A zeigt eine schematische Schnittdarstellung der Stromaufweitungsschicht des hier beschriebenen optoelektronischen Halbleiterchips.
Figur 2B zeigt eine schematische Schnittdarstellung einer Stromaufweitungsschicht die nicht Teil der Erfindung ist.
Figur 3 zeigt eine schematische Schnittdarstellung eines Ausführungsbeispiels des hier beschriebenen optoelektronischen Bauteils.
Figur 4 zeigt eine schematische Schnittdarstellung eines zweiten Ausführungsbeispiels des hier beschriebenen optoelektronischen Bauteils.

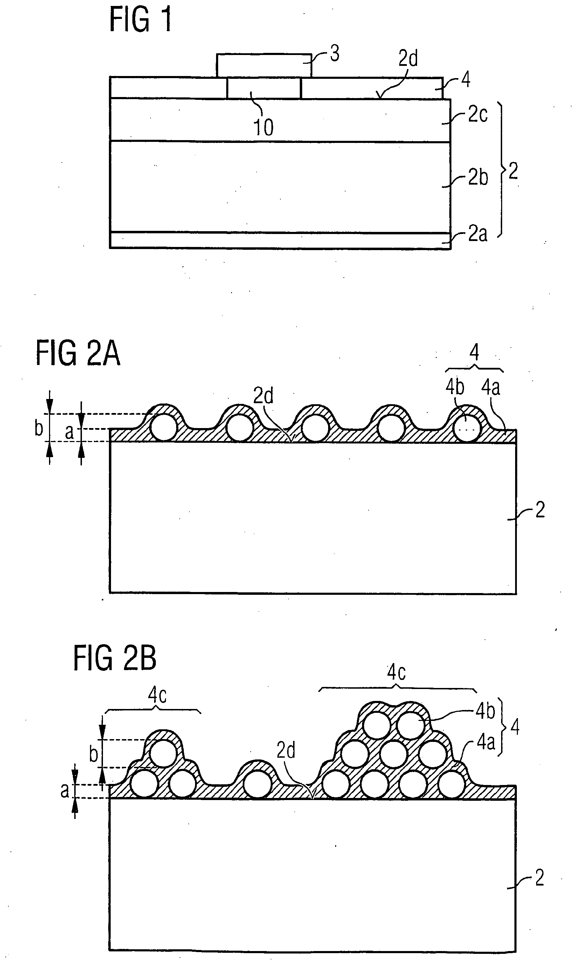

Figur 1 zeigt eine schematische Schnittdarstellung eines Ausführungsbeispiels des hier beschriebenen optoelektronischen Halbleiterchips 2. Bei dem optoelektronischen Halbleiterchip 2 handelt es sich beispielsweise um einen Leuchtdiodenchip.
Der optoelektronische Halbleiterchip 2 weist eine Kontaktschicht 2a auf, über die der Halbleiterchip 2 von seiner Unterseite her elektrisch kontaktierbar ist. Bei der Kontaktschicht 2a handelt es sich beispielsweise um eine Kontaktmetallisierung.
Ferner weist der optoelektronische Halbleiterchip 2 ein Substrat 2b auf. Bei dem Substrat 2b handelt es sich entweder um ein Aufwachssubstrat, auf das der aktive Bereich 2c des Halbleiterchips zum Beispiel epitaktisch aufgewachsen ist, oder um ein Trägerelement, auf das der aktive Bereich 2c aufgebracht, zum Beispiel aufgebondet ist.

Bevorzugt handelt es sich bei dem optoelektronischen Halbleiterchip um einen optoelektronischen Halbleiterchip 2 bei dem das Aufwachssubstrat zumindest teilweise entfernt ist und auf dessen dem ursprünglichen Aufwachssubstrat abgewandte Oberfläche ein Trägerelement aufgebracht ist. Das heißt, dass Aufwachssubstrat ist gedünnt oder vollständig entfernt.

Das Trägerelement kann, verglichen mit einem Aufwachssubstrat, relativ frei gewählt werden. Bevorzugt wird ein Trägerelement gewählt, das hinsichtlich seines Temperaturausdehnungskoeffizienten besonders gut an die strahlungserzeugende Epitaxieschichtenfolge angepasst ist. Weiter kann das Trägerelement ein Material enthalten, das besonders gut Wärme leitend ist. Auf diese Weise wird die im Betrieb vom optoelektronischen Halbleiterchip 2 erzeugte Wärme besonders effizient an beispielsweise einen Träger - etwa eine Leiterplatte - abgeführt.

Solche, durch das Entfernen des Aufwachssubstrats hergestellten optoelektronischen Halbleiterchips 2, werden oftmals als Dünnfilmchips bezeichnet und zeichnen sich bevorzugt durch zumindest eines der folgenden Merkmale aus:
- An einer zum Trägerelement hingewandten ersten Hauptfläche der strahlungserzeugenden Epitaxieschichtenfolge ist eine reflektierende Schicht oder Schichtenfolge aufgebracht oder ausgebildet, die zumindest einen Teil der in der Epitaxieschichtenfolge erzeugten elektromagnetischen Strahlung in diese zurückreflektiert.
- Die Epitaxieschichtenfolge weist bevorzugt eine Dicke von maximal 20 *µ*m, besonders bevorzugt von maximal 10 *µ*m auf.
- Weiter enthält die Epitaxieschichtenfolge bevorzugt mindestens eine Halbleiterschicht mit zumindest einer Fläche, die eine Durchmischungsstruktur aufweist. Im Idealfall führt diese Durchmischungsstruktur zu einer annähernd ergodischen Verteilung des Lichts in der Epitaxieschichtenfolge, d.h. sie weist ein möglichst ergodisch, stochastisches Streuverhalten auf.
Ein Grundprinzip eines Dünnfilmchips ist beispielsweise in der Druckschrift I. Schnitzer at al., Appl. Phys. Lett. 63(16), 18. Oktober 1993, Seiten 2174 bis 2176 beschrieben. Das heißt, der Halbleiterchip 2 weist eine Strahlungsdurchtrittsfläche 2d auf, durch die ein Großteil der vom optoelektronischen Halbleiterchip 2 zum Beispiel emittierten elektromagnetischen Strahlung ausgekoppelt wird. Besonders bevorzugt tritt die gesamte vom optoelektronischen Halbleiterchip 2 emittierte Strahlung durch die Strahlungsdurchtrittsfläche 2d aus. Die Strahlungsdurchtrittsfläche 2d ist beispielsweise durch einen Teil der Oberfläche des optoelektronischen Halbleiterchips 2 gegeben. Bevorzugt ist die Strahlungsdurchtrittsfläche (2d) durch eine Hauptfläche des optoelektronischen Halbleiterchips gegeben, die beispielsweise parallel zu einer Epitaxieschichtenfolge des optoelektronischen Halbleiterchips 2 angeordnet ist, welche geeignet ist, elektromagnetische Strahlung zu erzeugen.

Dazu kann die Epitaxieschichtenfolge beispielsweise einen pn-Übergang, eine Doppelheterostruktur, einen Einfach-Quantentopf oder eine Mehrfach-Quantentopfstruktur (MQW) aufweisen. Die Bezeichnung Quantentopfstruktur kann auch jegliche Struktur umfassen, bei der Ladungsträger durch Einschluss ("confinement") eine Quantisierung ihrer Energiezustände erfahren. Insbesondere beinhaltet die Bezeichnung Quantentopfstruktur keine Angabe über die Dimensionalität der Quantisierung. Sie umfasst somit unter Anderem Quantentröge, Quantendrähte und Quantenpunkte und jede Kombination dieser Strukturen. Eine Quantisierung der Energiezustände in der Quantentopfstruktur ist jedoch nicht zwingend erforderlich.

Der aktive Bereich 2c ist beispielsweise zur Strahlungserzeugung geeignet. Er weist an seiner vom Substrat 2b abgewandten Strahlungsoberfläche eine Strahlungsdurchtrittsfläche 2d auf. Auf die Strahlungsdurchtrittsfläche 2d ist eine Stromaufweitungsschicht 4 aufgebracht, die eine Gel-Schicht 4a und Partikel eines Wellenlängenkonversionsmaterials 4b umfasst (siehe auch die Figuren 2A, 2B).

Beispielsweise ist die Gel-Schicht aus einem Sol mit leitfähigen Nanopartikeln hergestellt. Zum Beispiel handelt es sich bei der Schicht um eine optisch transparente, nanokristalline und elektrisch leitende Schicht, wie etwa eine Zinkoxid- oder Zinnoxidschicht, die beispielsweise mit Aluminium oder Indium dotiert sein kann.

Das Sol enthält beispielsweise eine Konzentration zwischen 0,5 und maximal zwei Mol Zinkoxid-Nanopartikel pro Liter Lösungsmittel. Bevorzugt handelt es sich bei dem Lösungsmittel um Ethanol oder Isopropanol. Die Zinkoxid-Nanokristalle im Sol weisen bevorzugt Partikeldurchmesser zwischen drei und 30 Nanometer auf. Die Herstellung eines ZnO-Sols ist in der Druckschrift "Lubomir Spanhel and Marc A. Anderson, Semiconductor Clusters in the Sol-Gel Process: Quantized Aggregation, Gelation, and Crystal Growth in Concentrated ZnO Colloids, J. Am. Chem. Soc. 1991, 113, 2826-2833" im Abschnitt "Experimental Section" ausführlich beschrieben. Bevorzugt ist das Zinkoxid-Sol mit Aluminium oder Gallium dotiert.
Das Dotiermaterial kann beispielsweise durch Ko-Kondensation mit der Sol-Vorstufe, bevorzugt ein entsprechendes Metallalkoholat, in die Nanokristalle des Sols eingebracht werden. Es kann aber auch nach Kondensation der Vorstufe mit dem fertigen Sol gemischt werden.
Sol-Gel-Materialien können sich dabei durch die folgenden Vorteile auszeichnen: sie weisen eine hohe Oxidations- und UV-Beständigkeit, sowie nass- oder trockenchemische Ätzbarkeit auf und es stehen zahlreiche, beispielsweise lösungsmittelbasierte Beschichtungstechniken zum Aufbringen der Sol-Schicht zur Verfügung.
Beispielsweise handelt es sich bei den Partikeln 4b um Partikel eines Wellenlängenkonversionsmaterials wie es weiter oben beschrieben ist. Besonders bevorzugt handelt es sich um Leuchtstoffpartikel aus der Gruppe der Phosphore mit der allgemeinen Formel A₃B₅X₁₂:M. Dabei weisen die Partikel einen mittleren Durchmesser b (zum Beispiel d50 in Q0 gemessen) von drei bis 20 Mikrometer, bevorzugt maximal fünf Mikrometer, besonders bevorzugt zwischen einem und zwei Mikrometer auf. Besonders bevorzugt handelt es sich bei den Partikeln um YAG:Ce-Partikel.

Die Wellenlängenkonversionsmaterialpartikel 4b sind besonders gut geeignet, vom Leuchtdiodenchip 2 erzeugte elektromagnetische Strahlung im blauen Spektralbereich - mit einem Maximum der Intensität der emittierten Strahlung zwischen 430 Nanometer und 450 Nanometer - in gelbes Licht zu konvertieren. Unter Mischung des vom Halbleiterchip 2 abgestrahlten beispielsweise blauen Lichts mit dem vom Wellenlängenkonversionsmaterial reemittierten gelben Licht entsteht auf diese Weise weißes Licht.

Bevorzugt weist das Material 4 circa 40 Volumenprozent Wellenlängenkonversionsmaterialpartikel auf.

Das Material 4 ist mittels eines der folgenden Beschichtungsverfahren auf den optoelektronischen Halbleiterchip - bevorzugt im Wafer-Verbund - aufgebracht: Sprühen, Tauchbeschichten, Rotationsbeschichten, Siebdruck, Aufrakeln, Strahldruck, Aufpinseln. Bevorzugt befindet sich das Sol-Gel-Material dabei während des Beschichtungsvorgangs in seinem Sol-Zustand.

Alternativ zu einem Aufbringen des Materials, in dem bereits ein Wellenlängenkonversionsmaterial enthalten ist, ist es auch möglich, dass die Wellenlängenkonversionsmaterialpartikel erst nach dem Beschichten des Wafers mit dem Sol aufgebracht werden. Beispielsweise kann der mit Sol-Material beschichtete Wafer-Verbund dann mit einem Pulver, dass das Wellenlängenkonversionsmaterial umfasst, bestäubt oder besprüht werden. Auch auf diese Weise dient das Sol-Gel-Material als Haftmittel für die Wellenlängenkonversionsmaterialpartikel auf der Strahlungsaustrittsfläche 2d des optoelektronischen Halbleiterchips 2.

Die Schichtdicke der Schicht 4 ist zum einen durch die Parameter der verwendeten Beschichtungstechnik und zum anderen durch die Konzentration des Sols einstellbar.

Nach dem Beschichten wird das Material 4 getrocknet. Dazu wird die Anordnung beispielsweise für eine bestimmte Zeit auf Temperaturen zwischen 90 und 150 Grad Celsius, bevorzugt auf 100 Grad Celsius erhitzt. Der Trockenvorgang ist abgeschlossen, wenn zumindest der überwiegende Teil des Lösungsmittels aus dem Sol-Gel-Material entwichen ist. Das Sol ist dann zu einem relativ festen Gel getrocknet.

Auf die Stromaufweitungsschicht 4 wird im Folgenden eine Anschlussstelle 3, beispielsweise ein Bondpad, aufgebracht. Über das Bondpad kann der optoelektronische Halbleiterchip 2 elektrisch kontaktiert werden, die Stromaufweitungsschicht verteilt den so eingeprägten elektrischen Strom über die gesamte Strahlungsdurchtrittsfläche 2d des Halbleiterchips 2. Direkt unterhalb der Anschlussstelle 3 kann ein elektrisch isolierender Bereich 10 angeordnet sein, der eine Strahlungserzeugung direkt unterhalb der Anschlussstelle 3 unterdrückt.

Weiter ist es möglich, dass nach der Beschichtung des optoelektronischen Halbleiterchips und dem Trocknen zur elektrischen Aktivierung die Schicht getempert wird. Vorzugsweise wird die Schicht 4 bei Temperaturen zwischen 200 und 600 Grad Celsius, bevorzugt zwischen 300 und 500 Grad Celsius getempert. Das Tempern erfolgt vorzugsweise unter reduzierender Atmosphäre - beispielsweise in einem H2/N2-Gemisch. Durch das Tempern entsteht eine nanokristalline glasartige Schicht. Die reduzierende Atmosphäre unterdrückt das Entstehen von tiefen Ladungsträgerfallen durch Sauerstoff an der Oberfläche und / oder den Korngrenzen der Stromaufweitungsschicht. Das Tempern erweist sich dabei besonders zur Reduzierung des Schichtwiderstands als vorteilhaft.
Handelt es sich bei der Stromaufweitungsschicht 4 um ein mit Aluminium dotiertes Zinkoxid, findet das Tempern bevorzugt bei circa 400 Grad Celsius unter reduzierender Atmosphäre statt. Auch eine dem Tempern vorausgehende Infiltration der Schicht mit entsprechendem Sol sehr kleiner Kristallitgröße oder mit dessen Vorstufe kann die elektrische Leitfähigkeit der Stromaufweitungsschicht 4 verbessern. Die Infiltration einer aluminiumdotierten Zinkoxidschicht ist beispielsweise in der Druckschrift EP 0877099 beschrieben. Figur 2A zeigt eine schematische Schnittdarstellung der Stromaufweitungsschicht des hier beschriebenen optoelektronischen Halbleiterchips 2. Bei dem optoelektronischen Halbleiterchip 2 handelt es sich beispielsweise um einen Leuchtdiodenchip.
In der mikroskopischen Betrachtung, wie sie schematisch in der Figur 2A angedeutet ist, sind die Konturen der Wellenlängenkonversionsmaterialpartikel 4b in der Stromaufweitungsschicht 4 deutlich zu erkennen. Das Sol-Gel-Material 4a kann sich sowohl zwischen Strahlungsaustrittsfläche 2d und Partikeln 4b sowie auch auf den Partikeln 4b befinden. Das Sol-Gel-Material 4a vermittelt dadurch eine Haftung zwischen der Strahlungsaustrittsfläche 2d und den Partikeln des Wellenlängenkonversionsmaterials 4b. Weiter ist es auf diese Weise möglich, dass die elektrisch leitfähigen Nanopartikel des Sol-Gel-Materials 4a Strom von der Oberseite der Stromaufweitungsschicht 4 zur Strahlungsdurchtrittsfläche 2d des optoelektronischen Halbleiterchips 2 leiten. Bevorzugt ist das Sol-Gel-Material 4a so gewählt, dass es sowohl für die vom Leuchtdiodenchip 2 erzeugte elektromagnetische Strahlung als auch für die von den Wellenlängenkonversionsmaterialpartikeln reemittierte elektromagnetische Strahlung zumindest größtenteils transparent ist.
Es ist weiter möglich, dass das Wellenlängenkonversionsmaterial mehrere unterschiedlicher Konversionsmaterialien umfasst. So kann sich das Wellenlängenkonversionsmaterial beispielsweise aus Partikeln zusammensetzen, die blaues Licht in gelbes und Partikel, die blaues Licht in rotes Licht konvertieren. Dadurch erzeugtes weißes Licht zeichnet sich durch einen besonders guten Farbwiedergabewert aus.
Figur 2B zeigt eine schematische Schnittdarstellung in einer mikroskopischen Betrachtung einer Stromaufweitungsschicht die nicht Teil der Erfindung ist. Wie in der Figur 2A wird auch hier ein Großteil der im optoelektronischen Halbleiterchip 2 erzeugten elektromagnetischen Strahlung durch die Strahlungsdurchtrittsfläche 2d ausgekoppelt.
Die Strahlungsdurchtrittsfläche 2d ist zumindest stellenweise mit der Stromaufweitungsschicht 4 beschichtet. Die Stromaufweitungsschicht 4 umfasst ein Sol-Gel-Material 4a, das elektrisch leitfähige Nanopartikel enthält, und Partikel eines Wellenlängenkonversionsmaterials 4b.
Die mittlere Schichtdicke a der Stromaufweitungsschicht 4a beträgt bevorzugt zwischen 0,5 Mikrometer und zwei Mikrometer. Der mittlere Partikeldurchmesser b (zum Beispiel d50 in Q0 gemessen) der Wellenlängenkonversionsmaterialpartikel beträgt bevorzugt zwischen einem und fünf Mikrometer.
Wie der mikroskopischen Betrachtung der Figur 2B zu entnehmen ist, können Wellenlängenkonversionsmaterialpartikel 4b übereinander angeordnet sein. Auf diese Weise können mehrere Lagen 4c von Wellenlängenkonversionsmaterialpartikeln 4b auf der Strahlungsdurchtrittsfläche 2d angeordnet sein. Sol-Gel-Material 4a überzieht sowohl Wellenlängenkonversionsmaterialpartikel 4b im Inneren der Lagen 4c als auch am äußeren Rand der Lagen 4c zumindest teilweise. Die mittlere Schichtdicke a des Sol-Gel-Materials 4a ist dabei auch im Inneren der Lagen 4c bevorzugt kleiner als der mittlere Partikeldurchmesser b der Wellenlängenkonversionsmaterialpartikel 4b. Die Konturen der äußeren Partikel 4b der Lagen 4c sind auch in diesem Ausführungsbeispiel in der Stromaufweitungsschicht 4 deutlich zu erkennen.

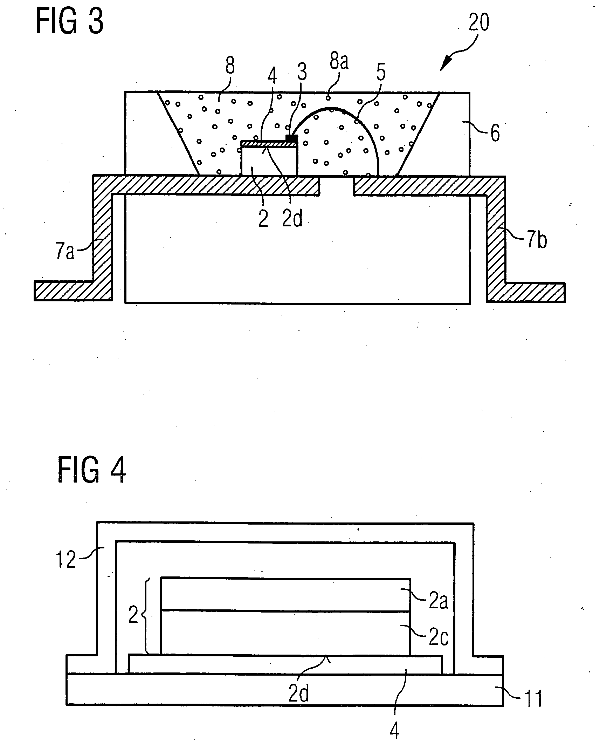

Figur 3 zeigt ein optoelektronisches Bauteil mit einem oben beschriebenen optoelektronischen Halbleiterchip. Bei dem Bauteil handelt es sich beispielsweise um eine Leuchtdiode 20.

Die Leuchtdiode 20 enthält einen Leuchtdiodenchip 2, dessen Strahlungsdurchtrittsfläche 2d mit einer Stromaufweitungsschicht 4 beschichtet ist, die ein Sol-Gel-Material 4a und Partikel eines Wellenlängenkonversionsmaterials 4b enthält. Beispielsweise in einer Ecke ist auf die Stromaufweitungsschicht 4 ein Bondpand 3 aufgebracht, über das der Leuchtdiodenchip mittels eines Bonddrahtes 5 kontaktiert ist. Die Stromaufweitungsschicht 4 verteilt den so eingeprägten elektromagnetischen Strom vom Bondpad 3 über die gesamte Strahlungsdurchtrittsfläche 2d des Halbleiterchips 2.

Der Halbleiterchip 2 ist mit seiner der Strahlungsaustrittsfläche 2d gegenüberliegenden Oberfläche elektrisch leitend und mechanisch stabil mit einem ersten Anschlussteil 7a verbunden. Ein Wire-Bonddraht 5 verbindet den optoelektronischen Halbleiterchip mit einem zweiten elektrischen Anschlussteil 7b elektrisch.

Der optoelektronische Halbleiterchip 2 ist in der Ausnehmung eines Gehäuses 6 angeordnet, dessen Innenwände beispielsweise reflektierend ausgestaltet sein können. Die Ausnehmung kann darüber hinaus eine Vergussmasse 8 enthalten, die zumindest für die vom Leuchtdiodenchip 2 erzeugte elektromagnetische Strahlung und die vom Wellenlängenkonversionsmaterial reemittierte elektromagnetische Strahlung transparent ist. Bei der Vergussmasse 8 handelt es sich beispielsweise um ein Epoxidharz, ein Silikonharz, ein Epoxid-Silikon-Hybridmaterial, PMMA und/oder eine Index Matching Gel. Es darüber hinaus auch möglich, dass die Ausnehmung mit einem Vergussmaterial 8 gefüllt ist, das ein Sol-Gel-Material, beispielsweise auf Basis von Siliziumdioxid, umfasst.

Ferner kann das Vergussmaterial 8 Partikel eines Wellenlängenkonversionsmaterials 8a umfassen. Dabei kann es sich um Partikel der weiter oben beschriebenen Wellenlängenkonversionsmaterialien handeln.

Figur 4 zeigt eine schematische Schnittdarstellung eines zweiten Ausführungsbeispiels des hier beschriebenen optoelektronischen Bauteils.

Bei dem in Zusammenhang mit Figur 4 beschriebenen Bauteil handelt es sich um eine organische Leuchtdiode. Die Stromaufweitungsschicht 4 steht hier mit einem Substrat 11 in Kontakt. Beispielsweise ist die Stromaufweitungsschicht 4 auf das Substrat 11 aufgebracht und in der oben beschriebenen Weise hergestellt. Alternativ ist es auch möglich, dass die Stromaufweitungsschicht 4 auf dem Halbleiterkörper 2 aufgebracht ist. In diesem Fall enthält der Halbleiterkörper 2 besonders temperaturstabile organische Materialien.

Bei dem Substrat 11 handelt es sich vorzugsweise um eine Glasplatte oder um eine Platte, die einen transparenten Kunststoff enthält. Dabei ist es auch möglich, dass das Substrat 1 flexibel ist und beispielsweise als Folie ausgebildet ist.

Der aktive Bereich 2c des organischen Halbleiterchips umfasst beispielsweise kleine organische Moleküle oder ein organisches Polymermaterial. Weiter kann der aktive Bereich Lochleitungs- und Elektronenleitungsschichten umfassen.

Auf der von der Strahlungsdurchtrittsfläche 2d abgewandten Seite des Halbleiterkörpers 2 befindet sich eine Kontaktschicht 2a. Die Kontaktschicht 2a fungiert beispielsweise als Kathode der organischen Leuchtdiode. Dazu weist die Kontaktschicht 2a vorzugsweise eine geringe Austrittsarbeit für Elektronen auf. Beispielsweise besteht die Kontaktschicht 2a aus einem der folgenden Materialien oder enthält eines der folgenden Materialien: Ca, Ba, Al, Ag.

Die Stromaufweitungsschicht 4 stellt vorzugsweise die Anode der organischen Leuchtdiode dar. Sie weist dazu eine hohe Austrittsarbeit für Elektronen auf. Die Stromaufweitungsschicht 4 enthält - wie weiter oben beschrieben - Partikel, die ein Wellenlängenkonversionsmaterial umfassen.

Im aktiven Bereich 2c wird beispielsweise elektromagnetische Strahlung aus dem ultravioletten und/oder blauen Spektralbereich erzeugt, die vom Wellenlängenkonversionsmaterial in der Stromaufweitungsschicht 4 vollständig oder teilweise in elektromagnetische Strahlung einer anderen Wellenlänge oder eines anderen Wellenlängenbereichs konvertiert wird.

Das in Figur 4 gezeigte optoelektronische Bauteil weist ferner eine Verkapselung 12 auf. Die Verkapselung 12 kann beispielsweise durch ein Kunststoffmaterial, durch Glas oder ein Metall gegeben sein.

## Patentansprüche

1. Optoelektronischer Halbleiterchip, mit einer Strahlungsdurchtrittsfläche (2d), die sich mit einer Stromaufweitungsschicht (4) in Kontakt befindet, wobei
- die Stromaufweitungsschicht (4) einen mittels einer Anschlussstelle (3) injizierten elektrischen Strom über die Strahlungsdurchtrittsfläche (2d) verteilt, und
- die Stromaufweitungsschicht (4) Partikel (4b) enthält, die ein Wellenlängenkonversionsmaterial umfassen, **dadurch gekennzeichnet, dass**
- die Partikel (4b) des Wellenlängenkonversionsmaterials einen mittleren Durchmesser (b) aufweisen, der größer ist als die mittlere Schichtdicke (a) der Stromaufweitungsschicht (4),
- das Material der Stromaufweitungsschicht (4a) die Partikel des Wellenlängenkonversionsmaterials (4b) vollständig benetzt und
- die Stromaufweitungsschicht (4) dotierte Nanopartikel enthält, wobei der mittlere Durchmesser der Nanopartikel wenigstens 1 nm und maximal 100 nm beträgt.

2. Optoelektronischer Halbleiterchip gemäß dem vorherigen Anspruch,
bei dem die Stromaufweitungsschicht (4) eine Haftung zwischen den Partikeln (4b) des Wellenlängenkonversionsmaterials und der Strahlungsdurchtrittsfläche (2d) vermittelt.

3. Optoelektronischer Halbleiterchip gemäß zumindest einem der vorherigen Ansprüche,
bei dem die mittlere Schichtdicke (a) der Stromaufweitungsschicht zwischen 0,2 und 2,0 µm beträgt.

4. Optoelektronischer Halbleiterchip gemäß zumindest einem der vorherigen Ansprüche,
bei dem die Stromaufweitungsschicht (4) ein Sol-Gel-Material (4a) enthält.

5. Optoelektronischer Halbleiterchip gemäß zumindest einem der vorherigen Ansprüche,
bei dem die Stromaufweitungsschicht (4) zumindest eines der folgenden Nanopartikel enthält: Zinkoxid, Zinnoxid.

6. Optoelektronischer Halbleiterchip gemäß zumindest einem der vorherigen Ansprüche,
bei dem die Stromaufweitungsschicht (4) Nanopartikel enthält, die mit wenigstens einem der folgenden Materialien dotiert sind: Bor, Aluminium, Gallium, Indium, Silizium, Magnesium.

7. Optoelektronischer Halbleiterchip gemäß zumindest einem der vorherigen Ansprüche,
bei dem die Stromaufweitungsschicht (4) ein mit Aluminium dotiertes Zinkoxid Sol-Gel-Material enthält.

8. Optoelektronischer Halbleiterchip gemäß zumindest einem der vorherigen Ansprüche,
bei dem die Stromaufweitungsschicht (4) ein mit Indium dotiertes Zinnoxid Sol-Gel-Material enthält.

9. Optoelektronischer Halbleiterchip gemäß zumindest einem der vorherigen Ansprüche,
bei dem das Wellenlängenkonversionsmaterial Partikel (4b) wenigstens eines der folgenden Farbstoffe umfasst: Organischer Farbstoff, anorganischer Farbstoff.

10. Optoelektronischer Halbleiterchip gemäß zumindest einem der vorherigen Ansprüche,
bei dem das Wellenlängenkonversionsmaterial Partikel (4b) wenigstens eines der folgenden Farbstoffe umfasst: mit Metallen der seltenen Erden dotierte Granate, mit Metallen der seltenen Erden dotierte Erdalkalisulfide, mit Metallen der seltenen Erden dotierte Thiogallate, mit Metallen der seltenen Erden dotierte Aluminate, mit Metallen der seltenen Erden dotierte Orthosilikate, mit Metallen der seltenen Erden dotierte Chlorosilikate, mit Metallen der seltenen Erden dotierte Erdalkalisiliziumnitride, mit Metallen der seltenen Erden dotierte Oxynitride, mit Metallen der seltenen Erden dotierte Aluminiumoxynitride.

11. Optoelektronischer Halbleiterchip gemäß zumindest einem der vorherigen Ansprüche,
bei dem das Wellenlängenkonversionsmaterial Partikel (4b) wenigstens eines der folgenden dotierten Granate umfasst: YAG:Ce, TAG:Ce, TbYAG:Ce.

12. Optoelektronischer Halbleiterchip gemäß zumindest einem der vorherigen Ansprüche,
bei dem der optoelektronische Halbleiterchip durch einen der folgenden Halbleiterchips gegeben ist: Photodiodenchip, Laserdiodenchip, anorganischer Leuchtdiodenchip.

13. Optoelektronischer Halbleiterchip gemäß zumindest einem der vorherigen Ansprüche,
bei dem der optoelektronische Halbleiterchip durch einen organischen Leuchtdiodenchip gegeben ist.

14. Optoelektronischer Halbleiterchip gemäß zumindest einem der vorherigen Ansprüche,
bei dem die Stromaufweitungsschicht (4) ein Sol-Gel-Material enthält und die Kontur der von der Strahlungsdurchtrittsfläche (2d) abgewandten Oberfläche der Stromaufweitungsschicht (4) durch die Partikel (4b) des Wellenlängenkonversionsmaterials bestimmt ist.

15. Optoelektronisches Bauteil
mit einem optoelektronischen Halbleiterchip gemäß zumindest einem der vorherigen Ansprüche und wenigstens zwei elektrischen Anschlussteilen (7a, 7b) zur Kontaktierung des Bauteils.

16. Optoelektronisches Bauteil gemäß dem vorherigen Anspruch,
bei dem sich die Stromaufweitungsschicht (4) des Halbleiterchips zumindest stellenweise in direktem Kontakt mit einem Formkörper (8) befindet.

17. Optoelektronisches Bauteil gemäß zumindest einem der vorherigen Ansprüche
bei dem der Formkörper (8) eines der folgenden Materialien enthält: Epoxid, Silikon, PMMA, Kopplungsgel.

18. Optoelektronisches Bauteil gemäß zumindest einem der vorherigen Ansprüche
bei dem der Formkörper (8) Partikel (8a) eines Wellenlängenkonversionsmaterials enthält.

19. Verfahren zur Herstellung eines optoelektronischen Halbleiterchips gemäß zumindest einem der vorherigen Ansprüche,
aufweisend die folgenden Schritte:
- Bereitstellen des Sols (4a), das dotierte Nanopartikel und Partikel (4b) des Wellenlängenkonversionsmaterials umfasst,
- Aufbringen zumindest einer Schicht (4) des Sols (4a) auf die Oberfläche eines Körpers (2d, 11), und
- thermisches Behandeln der aufgebrachten Schicht (4) zur Überführung des Sols in ein Gel.

20. Verfahren gemäß dem vorherigen Anspruch,
wobei die Schicht (4) des Sols (4a) mittels eines der folgenden Beschichtungsverfahren aufgebracht wird: Sprühen, Tauchen, Rotationsbeschichten, Siebdrucken, Aufrakeln, Strahldrucken, Aufpinseln.

21. Verfahren gemäß zumindest einem der vorherigen Ansprüche,
wobei die aufgebrachte Schicht (4) bei Temperaturen zwischen 300 und 500°C getempert wird.

22. Verfahren gemäß zumindest einem der vorherigen Ansprüche,
wobei die Gel-Schicht (4) zur Verbesserung der Leitfähigkeit der Schicht einer Infiltration unterzogen wird.

## Claims

1. Optoelectronic semiconductor chip, comprising a radiation passage area (2d), which is in contact with a current spreading layer (4), wherein
- the current spreading layer (4) distributes an electric current, injected by means of a connection location (3), over the radiation passage area (2d), and
- the current spreading layer (4) contains particles (4b) comprising a wavelength conversion material,
**characterized in that**
- the particles (4b) of the wavelength conversion material have an average diameter (b) that is greater than the average layer thickness (a) of the current spreading layer (4),
- the material of the current spreading layer (4a) completely wets the particles of the wavelength conversion material (4b), and
- the current spreading layer (4) contains doped nanoparticles, the average diameter of the nanoparticles being at least 1 nm and at most 100 nm.

2. Optoelectronic semiconductor chip according to the preceding claim,
in which the current spreading layer (4) imparts an adhesion between the particles (4b) of the wavelength conversion material and the radiation passage area (2d).

3. Optoelectronic semiconductor chip according to at least one of the preceding claims,
in which the average layer thickness (a) of the current spreading layer is between 0.2 and 2.0 µm.

4. Optoelectronic semiconductor chip according to at least one of the preceding claims,
in which the current spreading layer (4) contains a sol gel material (4a).

5. Optoelectronic semiconductor chip according to at least one of the preceding claims,
in which the current spreading layer (4) contains at least one of the following nanoparticles: zinc oxide, tin oxide.

6. Optoelectronic semiconductor chip according to at least one of the preceding claims,
in which the current spreading layer (4) contains nanoparticles doped with at least one of the following materials: boron, aluminum, gallium, indium, silicon, magnesium.

7. Optoelectronic semiconductor chip according to at least one of the preceding claims,
in which the current spreading layer (4) contains an aluminum-doped zinc oxide sol gel material.

8. Optoelectronic semiconductor chip according to at least one of the preceding claims,
in which the current spreading layer (4) contains an indium-doped zinc oxide sol gel material.

9. Optoelectronic semiconductor chip according to at least one of the preceding claims,
in which the wavelength conversion material comprises particles (4b) of at least one of the following dyes: organic dye, inorganic dye.

10. Optoelectronic semiconductor chip according to at least one of the preceding claims,
in which the wavelength conversion material comprises particles (4b) of at least one of the following dyes: garnets doped with rare earth metals, alkaline earth metal sulfides doped with rare earth metals, thiogallates doped with rare earth metals, aluminates doped with rare earth metals, orthosilicates doped with rare earth metals, chlorosilicates doped with rare earth metals, alkaline earth metal silicon nitrides doped with rare earth metals, oxynitrides doped with rare earth metals, aluminum oxynitrides doped with rare earth metals.

11. Optoelectronic semiconductor chip according to at least one of the preceding claims,
in which the wavelength conversion material comprises particles (4b) of at least one of the following doped garnets: YAG:Ce, TAG:Ce, TbYAG:Ce.

12. Optoelectronic semiconductor chip according to at least one of the preceding claims,
in which the optoelectronic semiconductor chip is provided by one of the following semiconductor chips: photodiode chip, laser diode chip, inorganic light emitting diode chip.

13. Optoelectronic semiconductor chip according to at least one of the preceding claims,
in which the optoelectronic semiconductor chip is provided by an organic light emitting diode chip.

14. Optoelectronic semiconductor chip according to at least one of the preceding claims,
in which the current spreading layer (4) contains a sol gel material and the contour of that surface of the current spreading layer (4) which is remote from the radiation passage area (2d) is determined by the particles (4b) of the wavelength conversion material.

15. Optoelectronic device comprising an optoelectronic semiconductor chip according to at least one of the preceding claims and at least two electrical connection parts (7a, 7b) for making contact with the device.

16. Optoelectronic device according to the preceding claim,
in which the current spreading layer (4) of the semiconductor chip is in direct contact with a molded body (8) at least in places.

17. Optoelectronic device according to at least one of the preceding claims,
in which the molded body (8) contains one of the following materials: epoxide, silicone, PMMA, coupling gel.

18. Optoelectronic device according to at least one of the preceding claims,
in which the molded body (8) contains particles (8a) of a wavelength conversion material.

19. Method for producing an optoelectronic semiconductor chip according to at least one of the preceding claims, having the following steps:
- providing the sol (4a) comprising doped nanoparticles and particles (4b) of the wavelength conversion material,
- applying at least one layer (4) of the sol (4a) to the surface of a body (2d, 11), and
- performing a thermal treatment of the applied layer (4) for the purpose of converting the sol into a gel.

20. Method according to the preceding claim,
the layer (4) of the sol (4a) being applied by means of one of the following coating methods: spraying, dipping, rotational coating, screen printing, blade coating, jet printing, brushing on.

21. Method according to at least one of the preceding claims,
the applied layer (4) being subjected to heat treatment at temperatures of between 300 and 500°C.

22. Method according to at least one of the preceding claims,
the gel layer (4) being subjected to an infiltration for the purpose of improving the conductivity of the layer.

## Revendications

1. Puce de semiconducteur optoélectronique, comprenant:
une surface de passage des rayonnements (2d), laquelle se trouve en contact avec une couche de propagation du courant (4);
selon laquelle
- la couche de propagation du courant (4) répartit un courant électrique, injecté au moyen d'un point de connexion (3) par l'intermédiaire de la surface de passage des rayonnements (2d); et
- la couche de propagation du courant (4) contient des particules (4b), qui comprennent un matériau de conversion des longueurs d'onde;
**caractérisée en ce que**
- les particules (4b) du matériau de conversion des longueurs d'onde présentent un diamètre moyen (b) qui est supérieur à l'épaisseur de couche moyenne (a) de la couche de propagation du courant (4);
- le matériau de la couche de propagation du courant (4a) humidifie complètement les particules du matériau de conversion des longueurs d'onde (4b); et
- la couche de propagation du courant (4) contient des nanoparticules dopées, selon laquelle le diamètre moyen des nanoparticules est compris entre au moins 1 nm et au plus 100 nm.

2. Puce de semiconducteur optoélectronique selon la revendication précédente,
pour laquelle la couche de propagation du courant (4) procure une adhérence entre les particules (4b) du matériau de conversion des longueurs d'onde et la surface de passage des rayonnements (2d).

3. Puce de semiconducteur optoélectronique selon tout au moins l'une des revendications précédentes,
pour laquelle l'épaisseur de couche moyenne (a) de la couche de propagation du courant est comprise entre 0,2 µm et 2,0 µm.

4. Puce de semiconducteur optoélectronique selon tout au moins l'une des revendications précédentes,
pour laquelle la couche de propagation du courant (4) contient un matériau de type sol-gel (4a).

5. Puce de semiconducteur optoélectronique selon tout au moins l'une des revendications précédentes,
pour laquelle la couche de propagation du courant (4) contient tout au moins l'une des nanoparticules suivantes: de l'oxyde de zinc, de l'oxyde d'étain.

6. Puce de semiconducteur optoélectronique selon tout au moins l'une des revendications précédentes,
pour laquelle la couche de propagation du courant (4) contient des nanoparticules, lesquelles sont dopées avec au moins l'un des matériaux suivants: du bore, de l'aluminium, du gallium, de l'indium, du silicium, du magnésium.

7. Puce de semiconducteur optoélectronique selon tout au moins l'une des revendications précédentes,
pour laquelle la couche de propagation du courant (4) contient un matériau de type sol-gel constitué d'oxyde de zinc, lequel est dopé avec de l'aluminium.

8. Puce de semiconducteur optoélectronique selon tout au moins l'une des revendications précédentes,
pour laquelle la couche de propagation du courant (4) contient un matériau de type sol-gel constitué d'oxyde d'étain, lequel est dopé avec de l'indium.

9. Puce de semiconducteur optoélectronique selon tout au moins l'une des revendications précédentes,
pour laquelle le matériau de conversion des longueurs d'onde (4b) comprend des particules d'au moins une des substances colorantes suivantes: un colorant organique, un colorant anorganique.

10. Puce de semiconducteur optoélectronique selon tout au moins l'une des revendications précédentes,
pour laquelle le matériau de conversion des longueurs d'onde particulaire (4b) comprend au moins l'une des substances colorantes suivantes: des grenats dopés au moyen de métaux des terres rares, des sulfures alcalino-terreux dopés au moyen de métaux des terres rares, des thiogallates dopés au moyen de métaux des terres rares, des aluminates dopés au moyen de métaux des terres rares, des orthosilicates dopés au moyen de métaux des terres rares, des chlorosilicates dopés au moyen de métaux des terres rares, des nitrures de silicium alcalino-terreux dopés au moyen de métaux des terres rares, des oxynitrures dopés au moyen de métaux des terres rares, des oxynitrures d'aluminium dopés au moyen de métaux des terres rares.

11. Puce de semiconducteur optoélectronique selon tout au moins l'une des revendications précédentes,
pour laquelle le matériau de conversion des longueurs d'onde particulaire (4b) comprend au moins l'un des grenats dopés suivants: YAG:Ce, TAG:Ce, TbYAG:Ce.

12. Puce de semiconducteur optoélectronique selon tout au moins l'une des revendications précédentes,
pour laquelle la puce de semiconducteur optoélectronique est constituée par l'une des puces de semiconducteur suivantes: puce à photodiode, puce de diode laser, puce de diode électroluminescente anorganique.

13. Puce de semiconducteur optoélectronique selon tout au moins l'une des revendications précédentes,
pour laquelle la puce de semiconducteur optoélectronique est constituée par une puce de diode électroluminescente organique.

14. Puce de semiconducteur optoélectronique selon tout au moins l'une des revendications précédentes,
pour laquelle la couche de propagation du courant (4) contient un matériau de type sol-gel et le contour de la surface de la couche de propagation du courant (4) qui se trouve à l'opposé de la surface de passage des rayonnements (2d) est déterminé par les particules (4b) du matériau de conversion des longueurs d'onde.

15. Élément de structure optoélectronique,
avec une puce de semiconducteur optoélectronique selon tout au moins l'une des revendications précédentes et avec au moins deux pièces de connexion électriques (7a, 7b) en vue de la mise en contact de l'élément de structure.

16. Élément de structure optoélectronique selon la revendication précédente,
pour lequel la couche de propagation du courant (4) de la puce de semiconducteur se trouve, tout au moins par endroits, en contact direct avec un corps moulé (8).

17. Élément de structure optoélectronique selon tout au moins l'une des revendications précédentes,
pour lequel le corps moulé (8) contient l'un des matériaux suivants: une résine époxy, de la silicone, du polyacrylate de méthyle (PMMA), du gel de couplage.

18. Élément de structure optoélectronique selon tout au moins l'une des revendications précédentes,
pour lequel le corps moulé (8) contient des particules (8a) d'un matériau de conversion des longueurs d'onde.

19. Procédé destiné à la fabrication d'une puce de semiconducteur optoélectronique selon tout au moins l'une des revendications précédentes, lequel procédé présente les phases suivantes:
- la mise en place du procédé de solution (4a), lequel comprend des nanoparticules et des particules (4b) dopées du matériau de conversion des longueurs d'onde;
- l'application de tout au moins une couche (4) du procédé de solution (4a) sur la surface d'un corps (2d, 11); et
- le traitement thermique de la couche (4) appliquée, en vue de la transition du procédé de solution en un gel.

20. Procédé selon la revendication précédente,
selon lequel la couche (4) du procédé de solution (4a) est appliquée au moyen de l'un des procédés de revêtement suivants: revêtement par vaporisation, par immersion, par centrifugation, par sérigraphie, à la lame, par sablage, par étalement au pinceau.

21. Procédé selon tout au moins l'une des revendications précédentes,
selon lequel la couche (4) appliquée est recuite à des températures comprises entre 300°C et 500 °C.

22. Procédé selon tout au moins l'une des revendications précédentes,
selon lequel la couche de gélification (4) destinée à améliorer la conductivité de la couche est soumise à une infiltration.
